# EUROPÄISCHE PATENTSCHRIFT

(11) **EP 0 652 819 B1**
(45) Veröffentlichungstag und Bekanntmachung des Hinweises auf die Patenterteilung: **15.01.1997**
(21) Anmeldenummer: 93914681.7
(22) Anmeldetag: 21.06.1993
(51) Int. Cl.: B29C 33/52, C25D 1/10

(54) **VERFAHREN ZUM HERSTELLEN VON MIKROSTRUKTURIERTEN KÖRPERN AUS EINEM KUNSTSTOFF**
PROCESS FOR MANUFACTURING MICRO-STRUCTURED BODIES MADE OF PLASTICS
PROCEDE DE FABRICATION DE CORPS MICROSTRUCTURES EN PLASTIQUE

(30) Priorität: 11.07.1992 DE 4222856
(43) Veröffentlichungstag der Anmeldung: 17.05.1995
(73) Patentinhaber: Forschungszentrum Karlsruhe GmbH, 76133 Karlsruhe (DE); BÜRKERT GMBH & CO. WERK INGELFINGEN, D-74653 Ingelfingen (DE)
(72) Erfinder: BACHER, Walter, D-7513 Stutensee (DE); BIEDERMANN, Hans, D-7520 Bruchsal 4 (DE); DINGLREITER, Heinz, D-7529 Forst (DE); KALB, Helmut, D-7514 Eggenstein (DE)
(74) Vertreter: Rückert, Friedrich, Dr.
(86) Internationale Anmeldenummer: EP9301571
(87) Internationale Veröffentlichungsnummer: WO9401262

(56) Entgegenhaltungen:
- EP-A- 0 328 161
- CH-A- 591 570
- US-A- 5 015 338

## Beschreibung

Die Erfindung betrifft ein Verfahren zum Herstellen von mikrostrukturierten Körpern aus einem Kunststoff, bei dem
a) ein mikrostrukturierter plattenförmiger Grundkörper eingesetzt wird, dessen erste Seite eine erste Bezugsfläche darstellt und dessen zweite Seite derart mikrostrukturiert ist, daß sich auf einem Strukturgrund Mikrostrukturkörper bestehend aus dem Kunststoff erheben, wobei der Strukturgrund und die Bezugsfläche zueinander parallel verlaufen,
b) die zweite, mikrostrukturierte Seite des Grundkörpers mit einem Werkstoff überschichtet wird,
c) die Oberfläche des den Grundkörper überschichtenden Werkstoffs parallel zur ersten Bezugsfläche plan bearbeitet wird, wodurch eine zweite Bezugsfläche gebildet wird,
d) der Grundkörper auf seiner ersten Seite zumindest soweit parallel zur zweiten Bezugsfläche abgetragen wird, bis der Strukturgrund erreicht ist, wonach
e) der Werkstoff selektiv gegenüber dem Kunststoff entfernt wird.

Aus der DE 40 10 669 C1 ist ein Verfahren zur Herstellung von galvanisch abformbaren Negativformen mikrostrukturierter, plattenförmiger Körper bekannt, wobei deren Strukturgrund eine zusammenhängende Fläche bildet und mit einer Schicht eines elektrisch leitenden Materials überzogen ist, bei dem auf eine Schicht eines Thermoplasten ein Film eines elektrisch leitenden Materials aufgebracht wird, ein mikrostrukturiertes Werkzeug (Formeinsatz) bei einer Temperatur, die oberhalb der Erweichungstemperatur des Thermoplasten liegt, durch den Film des elektrisch leitenden Materials hindurch in die Thermoplast-Schicht eingedrückt wird, das Werkzeug und die Thermoplast-Schicht auf eine Temperatur unterhalb der Erweichungstemperatur des Thermoplasten abgekühlt werden und das Werkzeug entfernt wird.

Die Negativformen können anschließend galvanisch abgeformt werden, wobei sich z. B. gitterartig mikrostrukturierte plattenförmige Körper (Netze o. ä.) aus Metall herstellen lassen. Mikrostrukturierte Körper aus Kunststoff lassen sich nach diesem Verfahren (abgesehen von der Negativform selbst) nicht herstellen. Ferner muß beim bekannten Verfahren der Strukturgrund in den Mikrovertiefungen eine zusammenhängende Fläche bilden. Bei der nachfolgenden galvanischen Abformung werden die Mikrovertiefungen mit Metall ausgefüllt, wobei der Strukturgrund der Mikrovertiefungen in den Negativformen zur Stirnfläche der Mikrostrukturkörper bei der durch die galvanische Abformung erhaltenen Positivform wird. Somit kann nach dem bekannten Verfahren nur ein einziger einteiliger mikrostrukturierter Körper, nicht dagegen eine Vielzahl von mikrostrukturierten Körpern, hergestellt werden.

Der Erfindung liegt die Aufgabe zugrunde, ein Verfahren anzugeben, mit mikrostrukturierte Körper aus Kunststoff hergestellt werden können. Mit dem Verfahren sollen sich gleichzeitig mehrere oder eine Vielzahl von mikrostrukturierten Körpern herstellen lassen.

Die Aufgabe wird durch das eingangs genannte Verfahren gelöst. Bevorzugte Ausgestaltungen des Verfahrens sind in den abhängigen Patentansprüchen beschrieben.

Endprodukt des erfindungsgemäßen Verfahrens sind z. B. mikrostrukturierte Körper in der Form von Netzen oder Gittern, wenn die Mikrostrukturkörper auf dem plattenförmigen Grundkörper eine zusammenhängende Struktur, etwa eine Wabenstruktur, bilden, oder eine Vielzahl von kleinen mikrostrukturierten Körpern beliebiger Gestalt, wenn die Mikrostrukturkörper inselartig gegeneinander abgesetzte, in sich zusammenhängende Strukturen bilden. Mit dem erfindungsgemäßen Verfahren lassen sich daher nicht nur ein mikrostrukturierter Körper, sondern zugleich mehrere oder viele kleinere mikrostrukturierte Körper herstellen, ohne daß Verfahrensschritte geändert werden. Die kleineren mikrostrukturierten Körper können gleichartig oder verschieden geformt sein. Die Gestalt der Endprodukte wird ausschließlich durch die Form und den Verbund der Mikrostrukturkörper auf dem Grundkörper bestimmt.

Das erfindungsgemäße Verfahren wird im folgenden anhand der Figuren 1 bis 9 erläutert.

Fig. 1 stellt schematisch das Herstellungsverfahren für den Grundkörper dar.

In Fig. 2 (2a und 2b) sind zwei für das erfindungsgemäße Verfahren einsetzbare Grundkörper gezeigt.

Die Fig. 3 bis 9 zeigen die Verfahrensschritte des erfindungsgemäßen Verfahrens ausgehend vom Grundkörper gemäß Fig. 2a.

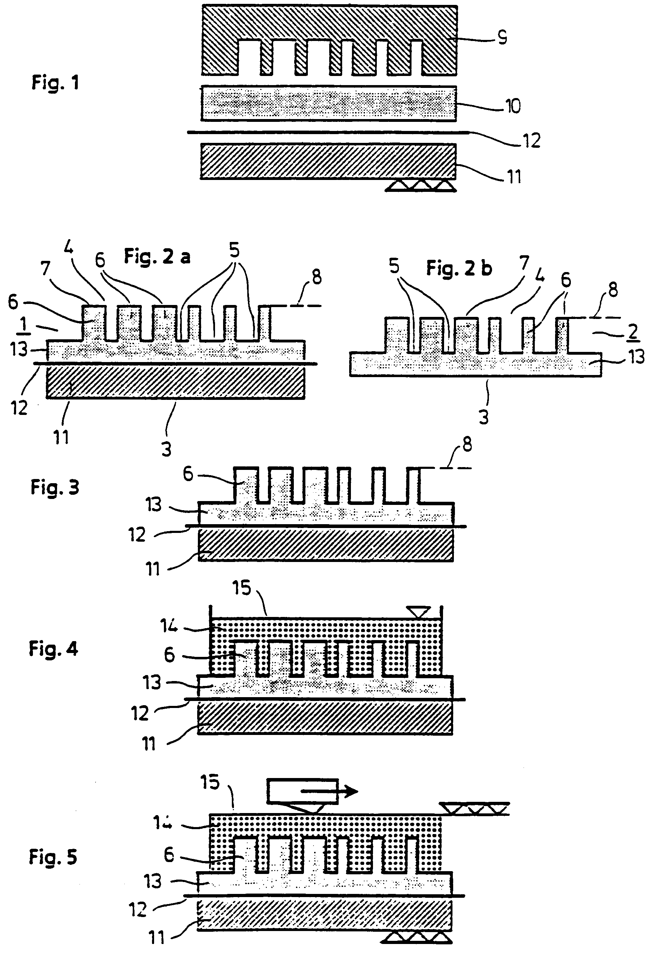

Erfindungsgemäß wird - wie in den Fig. 2a und 2b dargestellt - ein plattenförmiger Grundkörper 1, 2 eingesetzt, dessen erste Seite 3 eine erste Bezugsfläche darstellt und dessen zweite Seite 4 derart mikrostrukturiert ist, daß sich auf einem Strukturgrund 5 Mikrostrukturkörper 6 bestehend aus dem Kunststoff erheben. Als Bezugsflächen sind sehr genau plan bearbeitete, z. B. geschliffene Flächen einsetzbar. Die Stirnflächen 7 der Mikrostrukturkörper, d. h. diejenigen Flächen der Mikrostrukturkörper, die sich am höchsten über den Strukturgrund 5 erheben, liegen vorzugsweise auf einer gemeinsamen Ebene 8, wobei die Form der Mikrostrukturkörper 6 unerheblich ist. Die Mikrostrukturkörper 6 können im Querschnitt z. B. rechteckig, pyramiden- oder kegelstumpfförmig oder gestuft sein. Wie bereits erwähnt können die Mikrostrukturkörper 6 oder die Stirnflächen 7 eine zusammenhängende oder aber eine inselartige Struktur ausbilden, wobei nur die Mikrostrukturkörper innerhalb der "Inseln" zusammenhängen. Die einzelnen "Inseln" können untereinander gleich oder verschieden strukturiert sein. Im ersten Fall erhält man eine Vielzahl gleicher Endprodukte, im zweiten Fall mehrere verschiedene Endprodukte.

Die Bezugsfläche 3 der Grundkörper 1, 2 ist in einer solchen Qualität plan bearbeitet, daß die folgenden materialbearbeitenden Verfahrensschritte auf die Bezugsfläche 3 normiert werden können. Weiterhin ist notwendig, daß der Strukturgrund 5 genau parallel auf diese Bezugsfläche 3 ausgerichtet ist.

Die Herstellung des Grundkörpers kann nach verschiedenen, an sich bekannten Verfahren erfolgen (vgl. Fig. 1). Beispielsweise kann ein Werkzeug (Formeinsatz) 9 auf eine Kunststoffschicht 10 abgeformt werden. Bei einigen Verfahren wird die Abformung durch einen Metallstempel 11 unterstützt. Zwischen den Metallstempel 11 und die Kunststoffschicht wird vorzugsweise eine Trennfolie 12 gelegt.
1. Beim Vakuumprägeverfahren wird eine Thermoplast-Schicht vorzugsweise unter einem reduzierten Druck zwischen 1 und 10 mbar genau parallel auf ein Werkzeug (Formeinsatz) aufgedrückt. Die Prägetemperatur liegt dabei für amorphe Polymere oberhalb der Glasübergangstemperatur, für teilkristalline Polymere im Bereich des Kristallitschmelzpunkts. Als Handhabe für den Abformprozeß wird auf der dem Werkzeug abgewandten Seite des Thermoplasten z. B. ein mit Nuten versehener Metallstempel geeigneter Größe angebracht, damit die für den Entformvorgang erforderlichen Zugkräfte aufgebracht werden können. Der Thermoplast verbindet sich beim Zusammenpressen der Form mit den Nuten des Metallstempels formschlüssig. Die Rückseite des Metallstempels bildet für die erforderlichen weiteren Bearbeitungsschritte die Bezugsfläche; sie muß daher feinbearbeitet sein. Um den Metallstempel später von der strukturierten Thermoplast-Schicht trennen zu können, wird zwischen Metallstempel und Thermoplast eine Trennfolie, z. B. eine PTFE(Polytetrafluorethylen)-Folie, eingelegt. Alternativ kann der Metallstempel auch mit einem Trennmittel eingesprüht werden. Für verschiedene Thermoplaste, die sich durch gute intrinsische Gleiteigenschaften auszeichnen, beispielsweise für PVDF (Polyvinylidenfluorid), ist eine solche Trennschicht nicht erforderlich. Nach dem Prägen des Thermoplasts in der Form werden die Form und der Thermoplast unter die Erweichungstemperatur abgekühlt. Der Grundkörper wird mit Hilfe des Metallstempels vom Werkzeug getrennt. Er besteht - wie in Fig. 2a dargestellt - aus der mikrostrukturierten Kunststoffschicht 13 mit den Mikrostrukturkörpern 6 und dem Metallstempel 11, dessen freie Oberfläche 3 die Bezugsfläche darstellt.
2. Ein weiteres Verfahren zur Herstellung des Grundkörpers ist das Reaktionsgußverfahren. Hierbei wird ein flüssiges Gießharz in einen Hohlraum eingegossen, der aus dem Werkzeug (Formeinsatz) und dem sehr genau parallel dazu montierten, oben beschriebenen Metallstempel aufgebaut ist. Die Polymerisation des Gießharzes erfolgt anschließend in diesem Hohlraum. Wegen der formschlüssigen Verbindung zwischen polymerisiertem Gießharz und Metallstempel kann der Metallstempel wie oben beschrieben als Hilfsmittel zum Entformen der Mikrostrukturen und damit des Grundkörpers dienen. Damit der Grundkörper später vom Metallstempel getrennt werden kann, ist es sinnvoll, einen geeignet beschichteten Metallstempel, z. B. mit PTFE-Beschichtung, einzusetzen. Auch dieses Verfahren liefert einen Grundkörper aus dem Kunststoff 13, 6 und dem Metallstempel 11, dessen freie Oberfläche 3 die Bezugsfläche darstellt.
3a. Schließlich kann der Grundkörper auch nach dem Spritzgußverfahren hergestellt werden. Hierbei wird ein flüssiger Thermoplast unter hohem Druck in eine Form eingespritzt, die aus dem Formeinsatz und einer parallel zu dessen Oberfläche angeordneten ebenen Platte gebildet wird. Die Platte besteht vorzugsweise aus einem Metall, z. B. Edelstahl. In der Form wird der Kunststoff unter seine Erweichungstemperatur abgekühlt und anschließend entformt. Um die zur Entformung notwendigen Kräfte aufbringen zu können, werden beispielsweise Auswerferstifte verwendet. In diesem Fall erhält man - wie in Fig. 2b dargestellt - im Gegensatz zu den unter 1. und 2. beschriebenen Verfahren eine Kunststoffplatte 13 mit mikrostrukturierter Oberfläche und paralleler, ebener Rückseite 3, die die Bezugsfläche ist.
3b. Bei einem alternativen Spritzgußverfahren wird ein Metallstempel wie im unter 2. beschriebenen Verfahren anstatt der ebenen Platte eingesetzt.
   Dann können die erforderlichen Entformkräfte über den Formschluß der Spritzgießmasse zum Metallstempel aufgebracht werden. Dieses Alternativverfahren liefert einen Grundkörper, der dem gemäß der Verfahren 1. und 2. erhaltenen Grundkörper entspricht.

Bei allen Verfahren muß darauf geachtet werden, daß eine Bezugsfläche 3 erhalten wird, die sehr genau parallel zur Ebene, die vom Strukturgrund 5 gebildet wird, verläuft. Diese Bezugsfläche 3 wird entweder durch die feinbearbeitete Unterseite eines Metallstempels 11 (Verfahren 1., 2. und 3b.) oder durch die Abbildung einer ebenen Platte (Verfahren 3a.) gebildet. Die Parallelität der Bezugsfläche 3 und der Ebene des Strukturgrunds wird durch sehr genaue Parallelführung des Werkzeugs (Formeinsatzes) 9 zur Bezugsfläche erreicht.

Die Höhe der Mikrostrukturkörper 6 über dem Strukturgrund 5 kann bei dem für das erfindungsgemäße Verfahren einzusetzenden Grundkörper zwischen 1 und 1000 µm, vorzugsweise zwischen 1 und 500 µm, liegen. Die Mikrostrukturkörper 6 bestehen aus einem der bereits angesprochenen Kunststoffe (PVDF etc.) oder aus Polymethylmethacrylat (PMMA). Die Dicke der Schicht 13 zwischen dem Strukturgrund 5 und der ersten Bezugsfläche 3 (Grundkörper gemäß Verfahren 3a.) bzw. zwischen dem Strukturgrund 5 und der Grenzfläche zwischen der Schicht 13 und dem Metallstempel 11 (Grundkörper gemäß der Verfahren 1., 2., und 3b.) soll aus Gründen der mechanischen Stabilität einige Millimeter betragen. Diese Schicht 13 besteht in der Regel aus dem gleichen Kunststoff, aus dem auch die Mikrostrukturkörper gefertigt sind. Die Dicke des Metallstempels 11 beträgt zwischen 4 und 10 mm, vorzugsweise mindestens 6 mm. Für den Metallstempel ist jedes beliebige, leicht bearbeitbare und inerte Metall geeignet. Besonders geeignet ist Edelstahl.

Der Grundkörper 1, 2 wird - wie in Fig. 4 dargestellt - gemäß dem ersten Verfahrensschritt des erfindungsgemäßen Verfahrens z. B. mit Hilfe eines der bekannten Dickschichtverfahren mit einem Werkstoff 14 überschichtet. Die Dicke der Überschichtung beträgt vorzugsweise zwischen 2 und 4 mm beim Grundkörper gemäß Fig. 2b und mehr als 5 mm beim Grundkörper gemäß Fig. 2a, damit eine ausreichende mechanische Stabilität der Werkstoffschicht 14 einschließlich der darin eingebetteten Mikrostrukturkörper 6 gegen Verbiegen gewährleistet ist, nachdem in einem der folgenden Verfahrenschritte der Metallstempel 11 entfernt wird.

Als Werkstoff sind prinzipiell alle Stoffe geeignet, die sich einerseits haftfest mit dem Kunststoff der Mikrostrukturkörper 6 auf dem Grundkörper 1, 2 verbinden und sich andererseits selektiv gegenüber diesem Kunststoff etwa durch Auflösen entfernen lassen. Daneben ist eine gute mechanische Bearbeitbarkeit von Vorteil.

Erfindungsgemäß können jedoch auch Werkstoffe zum Überschichten verwendet werden, die an sich nicht selektiv vom Kunststoff der Mikrostrukturkörper entfernbar sind; beispielsweise kann auch der gleiche Kunststoff verwendet werden, aus dem die Mikrostrukturkörper 6 hergestellt sind. In diesem Fall müssen die Mikrostrukturkörper 6 auf dem Grundkörper 1, 2 vor dem Überschichten mit einer Schutz- bzw. Markierungsschicht (in den Figuren als fette Linie dargestellt) überzogen werden. Als Schutz- oder Markierungsschicht kann eine dünne Schicht etwa aus Gold, Titan oder einem Photolack verwendet werden, die sich selektiv von dem Kunststoff entfernen läßt. Durch eine solche Schicht werden die Mikrostrukturkörper abgedeckt, so daß sich der Werkstoff in einem nachfolgenden Verfahrensschritt entfernen läßt, ohne daß die Mikrostrukturkörper 6 angegriffen werden.

Eine Markierungsschicht wird vorzugsweise auch dann aufgebracht, wenn der Kunststoff, aus dem die Mikrostrukturkörper 6 bestehen, und der Werkstoff 14 zum Überschichten optisch nicht deutlich zu unterscheiden sind. In diesem Fall wird die nachfolgende Bearbeitung des Grundkörpers erleichtert, weil die Markierungsschicht den Übergang zwischen dem Kunststoff und dem Werkstoff zum Überschichten kennzeichnet.

Falls sich der vorgesehene Werkstoff zum Überschichten nicht ausreichend haftfest mit dem Kunststoff der Mikrostrukturkörper verbindet, kann die Markierungsschicht gleichzeitig als Haftvermittler dienen. Hierfür ist im allgemeinen eine Chromschicht gut geeignet.

Die Schutz- oder Markierungsschicht wird vorzugsweise in einer Dicke von 0,01 bis 10 µm aufgebracht. Jedoch kann - wie nachfolgend näher erläutert wird - auch eine wesentlich dickere Schutz- oder Markierungsschicht, etwa zwischen 10 µm und 1000 µm, vorteilhaft sein.

Geeignete Verfahren zum Aufbringen der Markierungsschicht sind z. B. Aufstäube (Sputter)-Verfahren, Aufdampf-, Sprüh- und Tauchverfahren.

In manchen Fällen kann es vorteilhaft sein, die Mikrostrukturkörper 6 auf dem Grundkörper 1, 2 vor dem Überschichten zu bearbeiten. In diesen Fällen wird der Überschichtungsachritt variiert. Der Strukturgrund auf dem Grundkörper wird zunächst nur dünn, etwa bis zur Höhe der Stirnflächen 7, aufgefüllt. Dann können die Stirnflächen, gegebenenfalls zusammen mit dem sie dünn überschichtenden Werkstoff 14, parallel zur Bezugsfläche 3 bearbeitet werden. Geeignete Bearbeitungsverfahren sind Mikrotomschnitte, Fräsbearbeitung mit Diamantwerkzeugen oder Schleif- und Polierverfahren. Nach der Bearbeitung wird die Dicke der Einbettung z. B. durch erneutes Übergießen erhöht. Dies ist nicht erforderlich, wenn z. B. gemäß dem oben beschriebenen Verfahren 3a. der Grundkörper - wie in Fig. 2b dargestellt - keinen Metallstempel enthält.

Im nächsten Verfahrensschritt wird die freie Oberfläche 15 des Werkstoffs, mit dem die Mikrostrukturkörper 6 überschichtet sind, parallel zur ersten Bezugsfläche 3 plan bearbeitet. Hierdurch wird eine zweite Bezugsfläche geschaffen, auf die der folgende Verfahrensschritt normiert wird. Die zweite Bezugsfläche verläuft zur ersten genau parallel.

Wenn der Grundkörper (wie in Fig. 2a gezeigt) einen Metallstempel 11 enthielt, wird dieser im nächsten Schritt entfernt. Hierzu wird beispielsweise der Metallstempel 11 festgehalten und der Verbund aus dem Kunststoff 6, 13 und dem überschichtenden Werkstoff 14 parallel zu den Nuten (in den Fig. nicht dargestellt) vom Metallstempel 11 geschoben. Hierbei erweist sich eine Oberflächenbeschichtung des Metallstempels oder die eingelegte Trennfolie 12 als vorteilhaft, weil dadurch die Haft- und Gleitreibung zwischen Metallstempel und Kunststoff stark vermindert wird. Wurde eine Trennfolie verwendet, kann diese durch einfaches Abziehen entfernt werden.

Durch die Oberflächenbearbeitung des überschichtenden Werkstoffs wurde eine neue Bezugsfläche 15 geschaffen, die parallel zur ersten Bezugsfläche ist. Diese Bezugsfläche wird für die weitere Bearbeitung genutzt.

Nunmehr kann der (ggf. vom Metallstempel 11 gelöste) Grundkörper parallel zur zweiten Bezugsfläche 15 auf seiner ersten Seite zumindest so weit abgetragen werden, bis der Strukturgrund 5 erreicht ist. Vom Grundkörper 1, 2 bleiben nach diesem Verfahrensschritt lediglich die Mikrostrukturkörper 6 bestehen.

Schließlich wird der Werkstoff 14 und gegebenenfalls die Schutz- oder Markierungsschicht (in den Fig. nicht dargestellt) selektiv entfernt; damit liegen die oben beschriebenen Endprodukte 16 des Verfahrens vor.

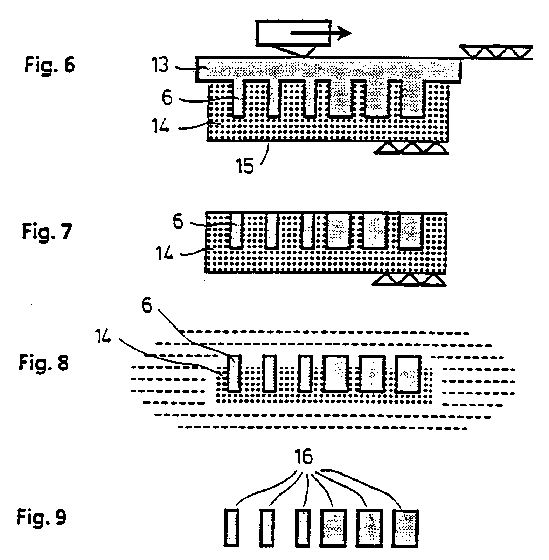

Die selektive Entfernung des Werkstoffs 14 erfolgt vorzugsweise durch selektives Auflösen des Werkstoffs 14 gegenüber dem Kunststoff der Mikrostrukturkörper 6. Alternativ kann die Oberfläche, in der die Mikrostrukturkörper freiliegen (Fig. 7) mit einer weiteren Schutz- oder Markierungsschicht bedeckt werden, wonach der Werkstoff 14 aufgelöst wird. Diese und die zuvor angebrachte Schutz- oder Markierungsschicht verhindern dabei, daß hierbei auch die Mikrostrukturkörper 6 angegriffen werden. Diese Schicht wird gegebenenfalls nachfolgend selektiv aufgelöst. Die Endprodukte 16 selbst können aus dem Lösungsmittelbad abfiltriert werden.

Wurde - wie oben erwähnt - eine dicke Schutz- oder Markierungsschicht aufgebracht, kann diese Schicht alternativ auch selektiv gegenüber dem Werkstoff 14 und dem Kunststoff 6, 13 aufgelöst werden. In diesem Fall liegen die Endprodukte 16 frei in der Schicht aus dem Werkstoff 14.

Beim erfindungsgemäßen Verfahren bilden die durch Abformen eines mikrostrukturierten Werkzeugs erhaltenen Mikrostrukturkörper direkt das Endprodukt des Verfahrens. Ein Umkopierschritt ist nicht erforderlich.

Mit dem erfindungsgemäßen Verfahren sind Endprodukte aus solchen Kunststoffen herstellbar, die bisher nicht eingesetzt werden konnten. Dies betrifft insbesondere Endprodukte aus thermoplastischen Kunststoffen wie PVDF. PVDF zeichnet sich durch seine hohe chemische und thermische Beständigkeit und seine guten intrinsischen Gleiteigenschaften aus. Da es chemisch inert ist, kann es in der Medizin- und Lebensmitteltechnologie eingesetzt werden.

Ein weiterer Vorteil des Verfahrens ist, daß in Kombination mit dem in der DE 41 26 877 C1 beschriebenen Verfahren ausgehend von einem einzigen mikrostrukturierten Werkzeug sowohl eine Positiv- als auch eine Negativform hergestellt werden kann.

Als Endprodukte können mit dem erfindungsgemäßen Verfahren z. B. Mikroventilsitze, uniporöse Filter, medizinische Implantate und Zahnräder hergestellt werden.

Die Erfindung wird im folgenden anhand von Durchführungsbeispielen näher erläutert.

### Beispiel 1

Mit einem handelsüblichen Kunststoffhalbzeug aus PVDF wurde nach dem oben beschriebenen Prägeverfahren ein Grundkörper gefertigt. Dazu wurde das Halbzeug auf einen Metallstempel aus Edelstahl aufgelegt und bei einer Temperatur von ca. 185 °C in ein mikrostrukturiertes Werkzeug gepreßt. Bei ca. 125 °C wurde mit Hilfe des Metallstempels entformt. Die Verwendung einer Trennfolie zwischen Metallstempel und Kunststoff ist bei PVDF nicht erforderlich, da PVDF intrinsische Gleiteigenschaften aufweist.

Der Grundkörper weist einen mikrostrukturierten Bereich von ca. 1200 mm² Fläche auf. Insgesamt befinden sich 47 einzelne, nicht über ihre Stirnflächen zusammenhängende Mikrostrukturkomponenten auf dem Grundkörper, die ihrerseits in sich nochmals mikrostrukturiert sind. Aus einem solchen Grundkörper können also in Parallelfertigung 47 Endprodukte gleichzeitig erhalten werden.

Die Mikrostrukturkörper weisen eine Höhe von ca. 500 µm auf; die Stirnflächen sind 10 bis 200 µm breit. Das Aspektverhältnis beträgt 25. Der Abstand der einzelnen Mikrostrukturkörper voneinander ist variabel.

Auf die mikrostrukturierte Seite dieses Grundkörpers wurde eine sehr dünne Goldschicht (ca. 20 nm) aufgestäubt.

Danach wurden die mit Gold beschichteten Mikrostrukturkörper durch Aufpolymerisieren mit einer ca. 4 mm dicken PMMA-Schicht überschichtet. Die Verarbeitung der PMMA-Schicht erfolgt bei Raumtemperatur. Der Aushärtevorgang wird durch Tempern bei ca. 100 °C beschleunigt.

Die Oberfläche der aufpolymerisierten PMMA-Schicht wurde mit einer Polierfräsmaschine parallel zur Unterseite des Metallstempels, der ersten Bezugsfläche, bearbeitet.

Anschließend wurde der Metallstempel abgetrennt und die dadurch freigelegte Schicht bearbeitet. Die plane Fläche der PMMA-Überschichtung diente als Bezugsfläche für diesen Bearbeitungsschritt. Das PVDF wurde bis zur aufgestäubten Markierungsschicht aus Gold mit Hilfe einer Fräsmaschine (Grobbearbeitung) und einer Polierfräsmaschine (Feinbearbeitung) abgetragen, so daß die Mikrostrukturkörper einzeln im Einbettmaterial PMMA freilagen.

Das aufpolymerisierte PMMA wurde anschließend selektiv gegenüber den PVDF-Mikrostrukturkörpern in Ethylacetat bei ca. 80° C in einer Zeit von ca. 30 min aufgelöst. Schließlich wurde die Markierungsschicht aus Gold in Königswasser von den Mikrostrukturkörpern weggeätzt.

### Beispiel 2

Das Verfahren gemäß Beispiel 1 wurde wiederholt, wobei jedoch ein Grundkörper aus PMMA verwendet wurde. Die Mikrostrukturkörper dieses Grundkörpers wurden ebenfalls mit einer aufgestäubten Goldschicht überzogen. Der Werkstoff zum Überschichten bestand ebenfalls aus PMMA. Vor dem Auslösen des Werkstoffs wurde die freiliegende Fläche der Mikrostrukturkörper durch erneutes Aufstäuben von Gold geschützt.

### Beispiel 3

Das Verfahren nach Beispiel 2 wurde wiederholt, wobei jedoch anstelle der aufgestäubten Markierungsschicht aus Gold eine ca. 50 nm dicke Kupferschicht durch Aufstäuben aufgebracht wurde. Die aufgestäubte Cu-Schicht wurde durch Aufgalvanisieren mit Cu auf eine Schichtdicke von ca. 50 µm erhöht und anschließend mit PMMA übergossen. Die Kupferschicht wurde abschließend durch ammonialkalische Chloritlösung als Lösungsmittel selektiv gegenüber den angrenzenden PMMA-Schichten entfernt, wonach die mikrostrukturierten Endprodukte der Einbettungschicht entnommen werden konnten.

## Patentansprüche

1. Verfahren zum Herstellen von mikrostrukturierten Körpern aus einem Kunststoff, bei dem
a) ein mikrostrukturierter plattenförmiger Grundkörper (1, 2) eingesetzt wird, dessen erste Seite (3) eine erste Bezugsfläche darstellt und dessen zweite Seite (4) derart mikrostrukturiert ist, daß sich auf einem Strukturgrund (5) Mikrostrukturkörper (6) bestehend aus dem Kunststoff erheben, wobei der Strukturgrund (5) und die Bezugsfläche (3) zueinander parallel verlaufen,
b) die zweite, mikrostrukturierte Seite (4) des Grundkörpers (1, 2) mit einem Werkstoff (14) überschichtet wird,
c) die Oberfläche des den Grundkörper überschichtenden Werkstoffs (14) parallel zur ersten Bezugsfläche (3) plan bearbeitet wird, wodurch eine zweite Bezugsfläche (15) gebildet wird,
d) der Grundkörper (1, 2) auf seiner ersten Seite (3) zumindest soweit parallel zur zweiten Bezugsfläche (15) abgetragen wird, bis der Strukturgrund (5) erreicht ist, wonach
e) der Werkstoff (14) selektiv gegenüber dem Kunststoff entfernt wird.

2. Verfahren nach Anspruch 1, dadurch gekennzeichnet, daß ein Grundkörper (2) eingesetzt wird, der vollständig aus dem Kunststoff besteht.

3. Verfahren nach Anspruch 1, dadurch gekennzeichnet, daß ein Grundkörper (1) aus einem Verbund des Kunststoffs mit einem Metall eingesetzt wird, bei dem die erste Seite (3) durch das Metall und die zweite Seite (4) durch den Kunststoff gebildet werden.

4. Verfahren nach Anspruch 1, 2 oder 3, dadurch gekennzeichnet, daß ein Grundkörper (1, 2) eingesetzt wird, der auf seiner zweiten Seite mit einer Markierungs- und/oder Schutzschicht überzogen ist.

5. Verfahren nach Anspruch 4, dadurch gekennzeichnet, daß der Werkstoff (14) in der Weise selektiv gegenüber dem Kunststoff entfernt wird, daß die Markierungs- und/oder Schutzschicht selektiv sowohl gegenüber dem Werkstoff als auch dem Kunststoff herausgelöst wird.

6. Verfahren nach Anspruch 1, dadurch gekennzeichnet, daß die Überschichtung der zweiten, mikrostrukturierten Seite des Grundkörpers gemäß Schritt b) in folgender Weise durchgeführt wird:
- Überschichten des Strukturgrundes (5) mit dem Werkstoff (14) auf ein Niveau, das im Bereich der Höhe der Mikrostrukturkörper (6) liegt,
- mechanische Bearbeitung der Mikrostrukturkörper (6),
- Überschichten der zweiten Seite (4) des Grundkörpers (1, 2) mit den mechanisch bearbeiteten Mikrostrukturkörpern (6) durch den Werkstoff (14).

7. Verfahren nach einem der Ansprüche 1 bis 3, dadurch gekennzeichnet, daß der mikrostrukturierte plattenförmige Grundkörper (1, 2) durch Abformung eines mikrostrukturierten Werkzeugs (9) mit Hilfe der an sich bekannten Vakuumpräge- , Reaktionsguß- oder Spritzgußverfahren hergestellt wird.

## Claims

1. Method of producing microstructured bodies from a plastics material, wherein
a) a microstructured, plate-like base body (1, 2) is used, the first side (3) of which represents a first reference face, and the second side (4) of which is microstructured in such a manner that microstructured bodies (6), formed from the plastics material, protrude from a structure base (5), the structure base (5) and the reference face (3) extending parallel to each other,
b) the second microstructured side (4) of the base body (1, 2) is coated with a material (14),
c) the surface of the material (14), which coats the base body, is processed in a planar manner parallel to the first reference face (3), whereby a second reference face (15) is formed,
d) the base body (1, 2) is abraded on its first side (3) parallel to the second reference face (15) at least until the structure base (5) is reached, whereupon
e) the material (14) is selectively removed from the plastics material.

2. Method according to claim 1, characterised in that a base body (2) is used, which is completely formed from the plastics material.

3. Method according to claim 1, characterised in that a base body (1) is used, which is formed from a combination of the plastics material with a metal, wherein the first side (3) is formed by the metal, and the second side (4) is formed by the plastics material.

4. Method according to claim 1, 2 or 3, characterised in that a base body (1, 2) is used, which is coated on its second side with a marker layer and/or protective layer.

5. Method according to claim 4, characterised in that the material (14) is selectively removed from the plastics material in such a manner that the marker layer and/or protective layer is selectively eliminated both from the material and from the plastics material.

6. Method according to claim 1, characterised in that the coating of the second microstructured side of the base body according to step b) is effected in the following manner:
- the structure base (5) is coated with the material (14) to a level which lies in the region of the height of the microstructured bodies (6),
- the microstructured bodies (6) are mechanically processed,
- the second side (4) of the base body (1, 2), provided with the mechanically processed microstructured bodies (6), is coated with the material (14).

7. Method according to one of claims 1 to 3, characterised in that the microstructured, plate-like base body (1, 2) is produced by moulding a microstructured tool (9) by means of the vacuum-stamping, reaction-moulding or injection-moulding processes known per se.

## Revendications

1. Procédé de fabrication de corps microstructurés en matière plastique dans lequel
a) un corps de base sous forme de plaque microstructuré est mis en oeuvre, dont la première face (3) représente une première surface de référence et dont la deuxième face (4) est microstructurée, de façon que des corps microstructurés (6) en matière plastique sur la base de structure (5) sont saillantes, pour lesquels la base de structure (5) et les surfaces de référence (3) s'étendent parallèlement l'un par rapport a l'autre,
b) la deuxième face microstructurée (4) du corps de base (1), (2) est enduite d'un matériau (14),
c) la surface du matériau (14), qui enduit le corps de base, est usinée en vue d'une première surface de référence (3) d'une manière plane, grâce à quoi une deuxième surface de référence (15) est formée,
d) le corps de base ((1), (2) sur sa première face (3) est abrasé au moins parallèlement à la deuxième surface de référence aussi loin que la base de structure (5) est atteinte, après quoi,
e) le matériau (14) est enlevé sélectivement vis-à-vis de la matière plastique.

2. Procédé selon la revendication 1,
caractérisé en ce que
l'on met en oeuvre un corps de base (2) qui est composé complètement de matière plastique.

3. Procédé selon la revendication 1,
caractérisé en ce qu*'*
un corps de base (1) en un matériau composite de matière plastique est mis en oeuvre avec un métal, dans lequel la première face (3) est formée par du métal et la deuxième face (4) par de la matière plastique.

4. Procédé selon la revendication 1, 2 ou 3,
caractérisé en ce que
l'on met en oeuvre un corps de base (1), (2) qui est enduit sur sa deuxième face d'une couche de marquage et/ou de protection.

5. Procédé selon la revendication 4,
caractérisé en ce que
le matériau (14) est enlevé d'une manière sélective vis-à-vis de la matière plastique, que la couche de marquage et/ou de protection est enlevée par dissolution d'une manière sélective aussi bien vis-à-vis du matériau qu'aussi de la matière plastique.

6. Procédé selon la revendication 1,
caractérisé en ce que
l'enduction de la deuxième face microstructurée du corps de base conformément à l'étape b) est effectué de la manière suivante :
a) enduction de la base de structure (5) avec le matériau (14) sur un niveau qui se situe dans la zone de la hauteur des corps microstructurés (6),
b) usinage mécanique des corps microstructurés (6),
c) enduction de la deuxième face (14) du corps de base (1) (2) avec les corps microstructurés usinés mécaniquement, par le matériau (14).

7. Procédé selon l'une des revendications 1 à 3,
caractérisé en ce que
le corps de base (1), (2) en forme de plaque, microstructuré, est fabriqué par moulage par un moule (9) microstructuré à l'aide des procédés connus en soi d'impression sous vide, de coulée par réaction ou de coulée par pulvérisation.
